# EUROPÄISCHE PATENTANMELDUNG

(11) **EP 1 168 431 A2**
(43) Veröffentlichungstag der Anmeldung: **02.01.2002**
(21) Anmeldenummer: 01115187.5
(22) Anmeldetag: 22.06.2001
(51) Int. Cl.: H01L 21/768

(54) **Verfahren zur Herstellung einer Verdrahtung für Kontaktlöcher**

(30) Priorität: 28.06.2000 DE 10032792
(71) Anmelder: Infineon Technologies AG, 81669 München (DE)
(72) Erfinder: Buerke, Axel, 01099 Dresden (DE); Schmidbauer, Sven, 01099 Dresden (DE); Hahn, Jens, Dr., 01099 Dresden (DE)
(74) Vertreter: Kindermann, Peter, Dipl.-Ing.

(57) **Zusammenfassung**

Die Erfindung betrifft ein Verfahren zur Herstellung einer Verdrahtung für Kontaktlöcher, wobei zum Ausbilden einer Al-GeCu-haltigen zweiten Verdrahtungsschicht (5) an der Oberfläche einer Isolationsschicht (2) ein Niedertemperatur-PVD-Verfahren zum Auffüllen von Kontaktlöchern (3) verwendet wird. Auf Grund der dabei ausgebildeten relativ kleinen Korngrößen und Ausscheidungen kann diese Schicht in einem nachfolgenden Strukturierungsschritt unmittelbar strukturiert werden, wodurch man eine äußerst zuverlässige Verdrahtung auf kostengünstige Art und Weise mit einfacher Integrierbarkeit in bestehende Prozess-Abläufe erhält.

## Beschreibung

Die vorliegende Erfindung bezieht sich auf ein Verfahren zur Herstellung einer Verdrahtung für Kontaktlöcher und insbesondere auf ein Verfahren zur einfachen und kostengünstigen Herstellung einer Verdrahtung mit Kontaktlöchern, die frei von störenden Hohlräumen sind.

Mit der zunehmenden Komplexität von integrierten Schaltungen sowie der steigenden Integrationsdichte erhöht sich einerseits die Anzahl von jeweiligen Verdrahtungs- bzw. Metallisierungsebenen einer integrierten Schaltung, wobei andererseits eine Strukturgröße von Kontaktlöchern zur Kontaktierung der jeweiligen Verdrahtungsebenen abnimmt. Die Kontaktlöcher dienen hierbei einer elektrischen Verbindung zwischen den verschiedenen Verdrahtungsebenen oder einer Substratebene, an der jeweilige elektrische Schaltungen ausgebildet sind. Ein Auffüllen dieser Kontaktlöcher bzw. Vias ohne Erzeugung von Hohlräumen sowie die einfache Strukturierung der nachfolgenden Verdrahtungsebene stellt bei der Herstellung einer Verdrahtung einer integrierten Schaltung bzw. eines Chips ein Schlüsselproblem dar.

Beispielsweise kommt es bei einer Metallabscheidung oberer Metallisierungsebenen (zweite, dritte usw. Ebene) oftmals zu einer Häufung von Material an den oberen Kanten des Kontaktloches bzw. Vias, was bis zum Blockieren einer Abscheidung im unteren Bereich des Kontaktloches und damit zur Ausbildung von sogenannten Voids bzw. Hohlräumen führen kann. Dieses Problem nimmt mit fortschreitender Integrationsdichte bzw. Verkleinerung der Durchmesser für die Kontaktlöcher und einer Tendenz zu immer steileren Seitenwänden der Kontaktlöcher in zukünftigen Verkleinerungsprozessen bzw. sogenannten Shrinks zu.

Zur Herstellung derartiger feinstrukturierter Kontaktlöcher mit hohen Aspektverhältnissen in mehrfachen Verdrahtungsebenen werden üblicherweise die vier nachfolgend beschriebenen Herstellungsverfahren angewendet.

In einem sogenannten W-CVD-Verfahren wird Wolfram unter Verwendung eines chemischen Dampfabscheideverfahrens (chemical vapor deposition, CVD) in den Kontaktlöchern ausgebildet, wobei sich dieses Verfahren durch gutes Füllverhalten auch bei sehr kleinen Abmessungen auszeichnet. Derartige Wolfram-Kontaktlöcher bringen jedoch eine Vielzahl von Nachteilen mit sich, die gegen einen Einsatz zur einfachen und kostengünstigen Herstellung einer Verdrahtung für Kontaktlöcher sprechen. Einerseits besteht während der Herstellung die Gefahr eines Ätzangriffs eines verwendeten Halbleitersubstrats durch das verwendete WF₆. Ferner besitzt Wolfram eine schlechte Adhäsion bzw. Haftfähigkeit zu SiO₂ und liefert dadurch mögliche Kontaktprobleme. Vor allem werden jedoch durch die Material-Heterogenität zwischen Wolfram-Kontaktlöchern und den jeweiligen Metallisierungsschichten der verschiedenen Verdrahtungsebenen, die vorzugsweise aus Al-Legierungen bestehen, Materialflussdivergenzen hervorgerufen. Diese Materialflussdivergenzen führen zur bevorzugten Ausbildung von Hohlräumen (Void-Bildung) an der Grenzfläche zwischen den Wolfram-Kontaktlöchern und der jeweiligen Metallisierung auf Grund von Elektro- und Stressmigration, wodurch sich eine Beeinträchtigung der Lebensdauer des gesamten Chips ergibt. Ferner spricht gegen den Einsatz von Wolfram-Vias gerade in zukünftigen Shrinks der gegenüber den Metallisierungsebenen bzw. Verdrahtungsebenen vergleichsweise hohe Kontaktwiderstand.

Alternativ zur vorstehend beschriebenen Wolfram-Abscheidung besteht die Möglichkeit einer chemischen Dampfabscheidung einer Aluminium-Metallisierung (Al-CVD-Abscheidung). Al-CVD-Verfahren konnten sich jedoch auf Grund ihrer geringen Abscheiderate für die Massenproduktion von integrierten Halbleiterschaltungen bzw. Chips nicht durchsetzen. Ferner führen die hohen Temperaturen von ≥ 500 Grad Celsius bei der Abscheidung zu sehr großen Körnern und damit verbundenen Schwierigkeiten beim nachfolgenden Strukturieren. Auch kann mittels dieses Al-CVD-Verfahrens eine Legierung wie z.B. Al0,5%Cu in geforderter Qualität nicht hergestellt werden. Ein derartiges Verfahren kann daher für die einfache und kostengünstige Herstellung einer Verdrahtung nicht angewendet werden.

Eine weitere Möglichkeit, Kontaktlöcher bzw. Vias ohne Hohlräume herzustellen, bietet das sogenannte Al-PVD-Sputtern (physical vapor deposition, PVD) bei hohen Temperaturen ≥ 500 Grad Celsius. Ein Modifikation dieses physikalischen Dampfabscheideverfahrens besteht in zunächst einer kalten Abscheidung zur Nukleation von Al-Keimen und einer nachfolgenden Temperaturerhöhung während des Sputterns. Auf diese Weise lässt sich zwar ein gutes Füllverhalten erzielen, wobei im Vergleich zu den Wolfram-Kontaktlöchern eine verbesserte Zuverlässigkeit erreicht wird. Allerdings werden durch die hohen Temperaturen bei der Abscheidung von ≥ 500 Grad Celsius die darunter liegenden Metallisierungsschichten bzw. Verdrahtungsebenen durch thermo-mechanische Beanspruchung (Stress) geschädigt. Ferner sind für das Füllen von Spalten und Hohlräumen durch Al-Diffusion sehr dicke Haftschichten aus Ti notwendig. Dies führt zusammen mit dem hohen Temperaturbudget zur Ausbildung einer ausgeprägten TiAl₃-Schicht, wodurch der Vorteil des geringeren Widerstands gegenüber den Wolfram-Kontaktlöchern wieder zunichte gemacht wird.

Eine weitere Möglichkeit zur Herstellung einer Verdrahtung für Kontaktlöcher sind sogenannte "Reflow-Verfahren". Bei diesen Verfahren wird nach dem konventionellen Sputtern eine Wärmebehandlung bei hoher Temperatur von vorzugsweise ≥ 500 Grad Celsius durchgeführt, bei der ein Füllmaterial in zuvor nicht gefüllte Kontaktlöcher bzw. deren Hohlräume fließen kann (reflow). Dieser Prozess ist wegen seiner geringen Kosten und seiner Einfachheit besonders effektiv für die Massenproduktion. Nachteilig ist jedoch auch bei diesem Verfahren, wie bei dem vorstehend beschriebenen Verfahren, die Schädigung der darunter liegenden Metallisierungsschichten bzw. Verdrahtungsebenen durch die hohe Prozess- bzw. Reflow-Temperatur und der zusätzlichen Ausbildung einer TiAl₃-Schicht vor dem Strukturieren mit ihrem unnötig hohen Widerstand. Eine Alternative hierzu bieten sogenannte "Laser-Reflow-Verfahren", bei denen die nachfolgende Wärmebehandlung der Metallisierungs- bzw. Verdrahtungsebenen lokal gesteuert mit einem Laserstrahl erfolgt. Eine Beeinträchtigung von unteren Metallebenen wird zwar dadurch verringert, eine kostengünstige Massenproduktion wird jedoch dadurch nicht ermöglicht.

Ferner ist beispielsweise aus der Druckschrift US 5,789,317 ein Verfahren bekannt, bei dem zur Herstellung einer Verdrahtung für Kontaktlöcher mittels eines Sputterabscheideverfahrens AlGeCu unter Verwendung von Wasserstoff (H) in den Kontaktlöchern abgeschieden wird, wodurch sich die Flusseigenschaften und das Risiko von entstehenden Hohlräumen wesentlich verringern lässt. Durch die Verwendung des Wasserstoffs werden hierbei die Metallbindungen gelockert und ein verbessertes Fließverhalten erreicht. Auf Grund der bei diesem Verfahren stark vergrößerten Rauhigkeit der Metallschicht muss jedoch in einem nachfolgenden Schritt zunächst ein chemisch-mechanisches Polieren (CMP) durchgeführt werden und eine nachfolgende Verdrahtungsschicht ganzflächig aufgebracht werden, welche einfach und fein strukturiert werden kann. Diese zusätzlichen Schritte bedeuten jedoch einen zusätzlichen Aufwand, nicht zuletzt an Kosten und Zeit, der darüber hinaus das Risiko eines verschlechterten Kontakts aufweist.

Der Erfindung liegt daher die Aufgabe zu Grunde, ein Verfahren zur Herstellung einer Verdrahtung für Kontaktlöcher mit geringen Abmessungen zu schaffen, welches einfach und kostengünstig eine zuverlässige Kontaktierung zwischen unterschiedlichen Verdrahtungsebenen ermöglicht.

Erfindungsgemäß wird diese Aufgabe durch die Maßnahmen des Patentanspruchs 1 gelöst.

Insbesondere durch das Ausbilden einer AlGeCu-haltigen zweiten Verdrahtungsschicht zum Auffüllen der Kontaktlöcher mittels eines PVD-Verfahrens und das unmittelbare Strukturieren der zweiten Verdrahtungsschicht mittels eines anisotropen Ätzverfahrens können Kontaktlöcher ohne Hohlräume bei niedrigen Temperaturen ausgebildet werden, wodurch keine Beeinträchtigung tieferliegender Verdrahtungsebenen bzw. Metallisierungsschichten erfolgt. Ein Ausbilden der intermetallischen Phase TiAl₃ mit ihren Schwierigkeiten beim Strukturieren wird dadurch minimiert, wobei die ausgebildete AlGeCu-Schicht ausreichend kleine Korngrößen aufweist, dass sie unmittelbar mittels eines anisotropen Ätzverfahrens strukturiert werden kann. Der üblicherweise vorhandene CMP-Schritt (chemical mechanical polishing) kann dadurch entfallen, wodurch sich das Verfahren weiter vereinfacht.

Vorzugsweise wird die zweite Verdrahtungsschicht in einem Einstufenprozess durch Abscheiden einer AlGeCu-Schicht bei Substrattemperaturen > 100 Grad Celsius ausgebildet. Üblicherweise liegen die Substrattemperaturen jedoch unterhalb von 420 Grad Celsius und somit weit unterhalb der sogenannten Reflow-Temperatur von > 500 Grad Celsius. Auf diese Weise kann die zweite Verdrahtungsschicht relativ schnell in den Kontaktlöchern ohne Ausbilden von Hohlräumen abgeschieden werden.

Ferner kann die zweite Verdrahtungsschicht in einem Zweistufenprozess durch Abscheiden einer ersten AlGeCu-Schicht bei niedrigen Temperaturen und einer zweiten AlGeCu-Schicht bei hohen Substrattemperaturen abgeschieden werden, wodurch sich die Fülleigenschaften in den Kontaktlöchern weiter verbessern lassen.

Alternativ kann in einem Zweistufenprozess die zweite Verdrahtungsschicht auch durch Abscheiden einer AlCu-Schicht bei niedrigen Substrattemperaturen < 100 Grad Celsius und einer AlGeCu-Schicht bei höheren Substrattemperaturen > 100 Grad Celsius ausgebildet werden. Dadurch erhält man verbesserte Fülleigenschaften und Kontaktwiderstände bei verkürzten Abscheidezeiten.

Gemäß einer weiteren Alternative kann die zweite Verdrahtungsschicht in einem Dreistufenprozess durch Abscheiden einer ersten AlCu-Schicht, einer AlGeCu-Schicht und einer zweiten AlCu-Schicht ausgebildet werden, wodurch man bei weiterhin optimalen Fließeigenschaften verbesserte Kontaktwiderstände und eine optimale Strukturierbarkeit erhält.

Vorzugsweise wird für die Barrierenschicht eine Ti-Haftschicht verwendet, deren Dicke auf Grund des verbesserten Fließverhaltens weiter verringert werden kann und somit wiederum kleinere Strukturgrößen ermöglicht.

Vorzugsweise wird für das anisotrope Ätzverfahren ein reaktives Ionenätzen unmittelbar auf die zweite Verdrahtungsschicht angewendet, wodurch man das Verfahren besonders einfach in bereits existierende Herstellungsprozesse integrieren kann.

In den weiteren Unteransprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

### Es zeigen:

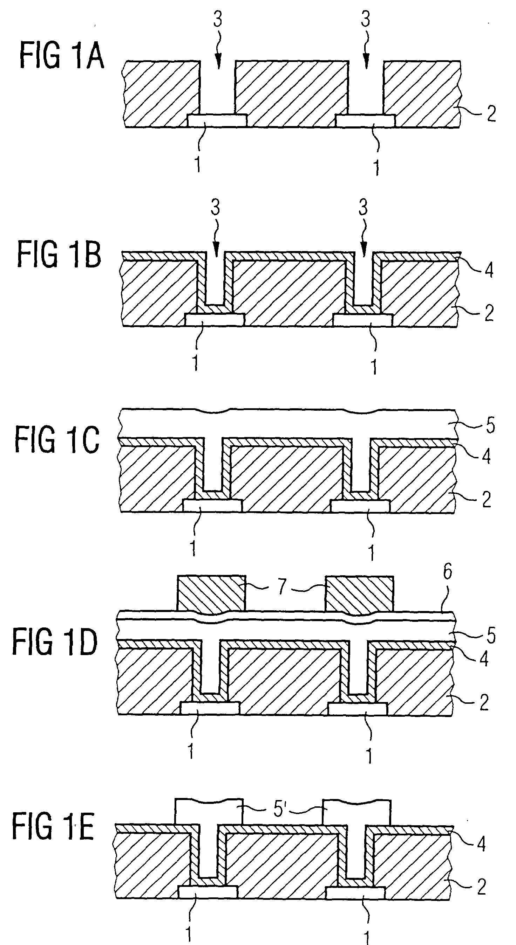

Figuren 1A bis 1E vereinfachte Schnittansichten zur Veranschaulichung von jeweiligen Schritten des erfindungsgemäßen Herstellungsverfahrens.

Figuren 1A bis 1E zeigen vereinfachte Schnittansichten von Verfahrensschritten zur Herstellung einer Verdrahtung für Kontaktlöcher gemäß der vorliegenden Erfindung, wobei gleiche Bezugszeichen gleiche oder ähnliche Schichten bzw. Elemente bezeichnen.

Gemäß Figur 1A befindet sich auf einem nicht dargestellten Substrat, in dem beispielsweise elektronische Schaltungen integriert sind, eine erste Verdrahtungsschicht 1. Die Verdrahtungsschicht 1 muss jedoch nicht unmittelbar auf einem Substrat aufliegen, sondern kann auch eine darüber liegende Zwischen-Verdrahtungsebene darstellen. Zur Isolierung von einer weiteren Verdrahtungsebene ist gemäß Figur 1A eine Isolationsschicht 2 oberhalb der ersten Verdrahtungsschicht 1 ausgebildet. Zur Herstellung einer elektrischen Verbindung zur ersten Verdrahtungsschicht 1 werden in einem nachfolgenden Verfahrensschritt feinstrukturierte Kontaktlöcher bzw. Vias 3 in der Isolationsschicht 2 ausgebildet. Die Isolationsschicht 2 besteht vorzugsweise aus Siliziumdioxid. Sie kann jedoch aus jedem weiteren Isolationsmaterial oder einer Vielzahl von Schichten bestehen. Nach dem Ausbilden der Kontaktlöcher 3, welches vorzugsweise durch ein anisotropes Ätzverfahren durchgeführt wird, erfolgt zur Reinigung insbesondere der Seitenoberflächen eine nasschemische und/oder plasmachemische Reinigung der Waber-Oberfläche bzw. der Kontaktlöcher 3.

Gemäß Figur 1B wird in einem nachfolgenden Verfahrensschritt eine Barrierenschicht 4 zumindest an der Oberfläche der Kontaktlöcher 3 ausgebildet, wobei sie vorzugsweise ganzflächig auf dem Wafer ausgebildet wird. Die Barrierenschicht 4 besteht vorzugsweise aus einer Ti-Haftschicht, wodurch sich ein Kontaktwiderstand zwischen der ersten Verdrahtungsschicht 1 und der nachfolgenden in den Kontaktlöchern ausgebildeten Verdrahtungsschicht verringert. Die Barrierenschicht bzw. Haftschicht 4 kann hierbei sehr dünn ausgestaltet sein, wodurch sehr feinstrukturierte Kontaktlöcher 3 mit steilen Flanken hergestellt werden können.

Gemäß Figur 1C wird in einem weiteren Verfahrensschritt eine AlGeCu-haltige zweite Verdrahtungsschicht 5 an der Oberfläche der Isolationsschicht 2 mittels eines physikalischen Dampfabscheideverfahrens (PVD, physical vapor deposition) abgeschieden, wodurch die Kontaktlöcher 3 ohne Hohlräume aufgefüllt werden. Die Temperaturen zum Ausbilden dieser AlGeCu-haltigen zweiten Verdrahtungsschicht 5 liegen hierbei deutlich unter den üblichen Reflow-Temperaturen von > 500 Grad Celsius und vorzugsweise unterhalb von 400 Grad Celsius. Insbesondere auf Grund der Verwendung eines Ge-haltigen AlCu-Targets kann somit bei sehr geringen Temperaturen eine hoch fließfähige und elektrisch leitende Schicht in den Kontaktlöchern 3 ausgebildet werden. Die zweite Verdrahtungsschicht 5 besitzt demzufolge zumindest eine Schicht aus der Legierung Al_{(1-x-y)}GeₓCu_{y}. Da sich aus dem Al-Ge-Phasendiagramm eine eutektische Temperatur von 420 Grad Celsius bei 5 Gewichtsprozent Ge ergibt, kann durch die Verwendung dieses physikalischen Niedertemperaturverfahrens auch bei einem geringeren Ge-Anteil eine ausreichend fließfähige Metallisierungsschicht in den Kontaktlöchern 3 bei Temperaturen ausgebildet werden, die weit unterhalb der Reflow-Temperaturen von > 500 Grad Celsius und üblicherweise unterhalb von 420 Grad Celsius liegen.

Gemäß Figur 1D wird in einem nachfolgenden Schritt eine Antireflexionsschicht 6 an der Oberfläche der zweiten Verdrahtungsschicht 5 ausgebildet, die eine sehr präzise Strukturierung der zweiten Verdrahtungsschicht ermöglicht. In einem nachfolgenden Schritt wird beispielsweise eine Maskenschicht 7 ausgebildet und strukturiert, wobei vorzugsweise fotolithographische Verfahren zur Anwendung kommen.

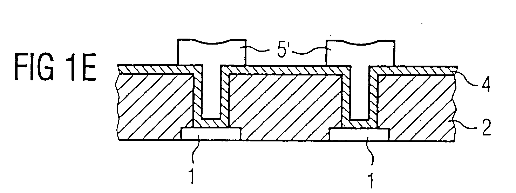

Gemäß Figur 1E wird unter Verwendung der Maskenschicht 7 nunmehr unmittelbar die zweite Verdrahtungsschicht 5 mittels eines anisotropen Ätzverfahrens zur Ausbildung einer zweiten Verdrahtungsebene 5' strukturiert, wobei auf Grund des vorstehend beschriebenen Niedertemperatur-PVD-Verfahrens die Korngrößen der AlGeCu-haltigen zweiten Verdrahtungsschicht ausreichend klein sind, um eine genügend präzise Strukturierung zu erhalten. Das üblicherweise erforderliche CMP-Verfahren mit anschließender Ausbildung einer weiteren Metallisierungsschicht entfällt dadurch, wobei keinerlei sich negativ auswirkende Kontaktwiderstände zwischen der Metallisierungsschicht innerhalb und außerhalb der Kontaktlöcher 3 entstehen.

Demzufolge erhält man ein einfaches und kostengünstiges Herstellungsverfahren, bei dem eine besonders zuverlässige Verdrahtung für Kontaktlöcher erzeugt werden kann.

Nachfolgend werden verschieden Ausführungsformen zur Ausbildung der zweiten Verdrahtungsschicht beschrieben.

Gemäß einer ersten Ausführungsform wird eine AlGeCu-Schicht als zweite Verdrahtungsschicht 5 in einem Einstufenprozess durch eine PVD-Abscheidung bei erhöhten Substrattemperaturen > 100 Grad Celsius in den Kontaktlöchern 3 sowie an der Oberfläche der Isolationsschicht 2 ausgebildet. Vorzugsweise wird eine PVD-Abscheidung angewendet, bei der ein Ge-haltiges Target (mit homogener Ge-Verteilung) beschossen wird. Bei derartigen Temperaturen des Substrats, die jedoch noch deutlich unterhalb von üblichen Reflow-Temperaturen > 500 Grad Celsius liegen, erhält man ein verbessertes Fließverhalten der neuen Legierung Al_{(1-x-y)}GeₓCu_{y}. Dadurch wird ein sogenanntes void-freies Füllen der Kontaktlöcher ermöglicht und ein ausreichender Kontakt zwischen jeweiligen Metallisierungs- bzw. Verdrahtungsebenen sichergestellt. Das Verfließen des eingebrachten Materials kann demzufolge schon während der Abscheidung erfolgen, was insbesondere bei sehr fein strukturierten Kontaktlöchern von Vorteil ist.

Ferner werden auf Grund der relativ geringen Temperaturen bei der PVD-Abscheidung unterhalb von 500 Grad Celsius die darunter liegenden Metallisierungsschichten durch thermo-mechanische Beanspruchung nicht geschädigt und eine relativ feinkörnige AlGeCu-Schicht ausgebildet, die in einem nachfolgenden anisotropen Ätzverfahren unmittelbar strukturiert werden kann, wodurch sich eine Verdrahtung besonders schnell und einfach realisieren lässt. Üblicherweise angewendete CMP-Verfahren können demzufolge entfallen. Zur Verbesserung des Kontaktwiderstands dient darüber hinaus die an der Oberfläche der Kontaktlöcher 3 ausgebildete Barrierenschicht 4, die vorzugsweise aus Ti besteht.

Gemäß einer zweiten Ausführungsform kann die zweite Verdrahtungsschicht 5 alternativ auch in einem Zweistufenprozess durch PVD-Sputtern einer ersten AlGeCu-Schicht bei Substrattemperaturen < 100 Grad Celsius und einer zweiten AlGeCu-Schicht bei Substrattemperaturen > 100 Grad Celsius ausgebildet werden. Da im Wesentlichen die gleichen Materialien und Abscheideverfahren wie bei der ersten Ausführungsform verwendet werden, wird auf deren detaillierte Beschreibung nachfolgend verzichtet. Wiederum wird beispielsweise aus einem Ge-haltigen AlCu-Target mit homogener Ge-Verteilung die AlGeCu-Schicht erzeugt, wobei sich für die Legierung bei 5 Gewichtsprozent Ge eine eutektische Temperatur von ca. 420 Grad Celsius ergibt und somit die zweite Verdrahtungsschicht bei Temperaturen deutlich < 420 Grad Celsius ausgebildet werden kann. Durch die Verwendung des vorstehend beschriebenen Zweistufenprozesses, bei dem mit relativ hohem Zeitaufwand und bei relativ geringen Temperaturen unterhalb von 100 Grad Celsius eine erste relativ dünne AlGeCu-Schicht ausgebildet wird und einer nachfolgenden Ausbildung einer zweiten AlGeCu-Schicht bei Substrattemperaturen > 100 Grad Celsius, welche in der Regel sehr schnell durchgeführt werden kann, erhält man eine besonders zuverlässige Verdrahtung, bei der keinerlei Hohlräume in den Kontaktlöchern ausgebildet werden. Auch diese in einem Zweistufenprozess ausgebildete AlGeCu-Schicht besitzt wiederum eine sehr kleine Korngröße, weshalb in einem nachfolgenden Strukturierungsschritt diese Schicht unmittelbar zur Ausbildung der eigentlichen Verdrahtung strukturiert werden kann.

Gemäß einer dritten Ausführungsform wird die zweite Verdrahtungsschicht 5 in einem Zweistufenprozess durch Abscheiden einer AlCu-Schicht bei Substrattemperaturen < 100 Grad Celsius und einer AlGeCu-Schicht bei Substrattemperaturen > 100 Grad Celsius ausgebildet. Die Verfahren zum PVD-Abscheiden der AlGeCu-Schicht entsprechen hierbei wiederum den vorstehend beschriebenen Abscheideverfahren, weshalb auf eine detaillierte Beschreibung nachfolgend verzichtet wird. Zur weiteren Verbesserung einer Abscheidung in den Kontaktlöchern 3 sowie auf der ersten Verdrahtungsschicht 1, welche vorzugsweise aus AlCu besteht, kann gemäß dieser dritten Ausführungsform zunächst eine AlCu-Schicht in einem sogenannten Kaltprozess ausgebildet werden. Auf Grund der niedrigen Temperaturen erhält man wiederum eine relativ geringe Abscheiderate, wobei jedoch die Güte verbessert ist. Wie bei der zweiten Ausführungsform erhält man dadurch eine weiter verbesserte Verdrahtung, die nunmehr aus zwei unterschiedlichen Schichten besteht und sich wiederum sehr gut strukturieren lässt.

Gemäß einer vierten Ausführungsform wird die zweite Verdrahtungsschicht 5 in einem Dreistufenprozess durch Abscheiden einer ersten AlCu-Schicht, einer nachfolgenden AlGeCu-Schicht und einer nachfolgenden zweiten AlCu-Schicht ausgebildet. Die Verfahren insbesondere zur Ausbildung der AlGeCu-Schicht entsprechen hierbei wiederum den vorstehend beschriebenen Ausführungsformen, weshalb auf eine detaillierte Beschreibung nachfolgend verzichtet wird. Zusätzlich zu der ersten AlCu-Schicht wird gemäß dieser Ausführungsform eine weitere AlCu-Schicht als Deckschicht der AlGeCu-Schicht überlagert, wodurch sich der Schichtwiderstand, die Zuverlässigkeit der Verdrahtung sowie die Strukturierungseigenschaften weiter verbessern. Die einzelnen Schichten können hierbei bei verschiedenen Substrattemperaturen ausgebildet werden, wobei jedoch vorzugsweise zunächst ein Kaltprozess und anschließend heißere Prozesse bei Substrattemperaturen unterhalb bzw. oberhalb von 100 Grad Celsius angewendet werden.

Gemäß einer weiteren Ausführungsform wird die zweite Verdrahtungsschicht in einem Mehrstufenprozess durch Abscheiden von zumindest einer AlGeCu-Schicht in den Kontaktlöchern 3 gefolgt von einem chemisch-mechanischen Polieren (CMP) und durch darauffolgendes ganzflächiges Abscheiden einer AlCu-Schicht an der Oberfläche der Isolationsschicht 2 ausgebildet. Wiederum entsprechen die jeweiligen Abscheideverfahren den vorstehend beschriebenen Abscheideverfahren, weshalb auf eine wiederholte Beschreibung nachfolgend verzichtet wird. Gemäß dieser Ausführungsform befindet sich die AlGeCu-Schicht nur in den jeweiligen Bereichen der Kontaktlöcher 3, während ein restlicher Teil der Oberfläche ganzflächig mit einer AlCu-Schicht überzogen wird. Auf diese Weise erhält man wiederum bei den Kontaktlöchern 3 optimale Fließ- und Fülleigenschaften zur Erzeugung hoch zuverlässiger und hohlraumfreier Kontakte, während die gesamte zweite Verdrahtungsschicht 5 einen minimalen Schichtwiderstand besitzt. Darüber hinaus ist eine Strukturierung mittels anisotroper Ätzverfahren weiter verbessert, da die an der Isolationsschicht 2 ausgebildete AlCu-Schicht minimale Schichtwiderstände sowie kleinere Korngrößen aufweist und somit eine feinere Strukturierung ermöglicht.

Zur Strukturierung der zweiten Verdrahtungsschicht 5 wird als anisotropes Ätzverfahren vorzugsweise ein reaktives Ionenätzen (RIE) verwendet. Auf diese Weise kann das vorstehend beschriebene Verfahren problemlos in bereits existierende Verfahren eingebettet werden. Ferner kann zur Verbesserung von jeweiligen Materialeigenschaften bei allen vorstehend beschriebenen Ausführungsformen zusätzlich eine Wärmebehandlung durchgeführt werden. Zur Verbesserung der Strukturierung der zweiten Verdrahtungsschicht 5 besteht die Antireflexionsschicht 6 vorzugsweise aus einer TiN-Schicht, wodurch sich insbesondere bei Verwendung von fotolithographischen Strukturierungsverfahren störende Streulichter gezielt verringern lassen.

Die vorliegende Erfindung wurde anhand einer ersten und zweiten Verdrahtungsschicht beschrieben. Diese erste und zweite Verdrahtungsschicht ist jedoch nicht auf eine erste und zweite Metallisierungsebene beschränkt, sondern kann vielmehr auf alle Verdrahtungsebenen innerhalb einer integrierten Schaltung bzw. eines Halbleiterbausteins angewendet werden. Insbesondere durch die Verwendung eines speziellen Niedertemperatur-PVD-Sputter-Verfahrens erhält man eine AlGeCu-Schicht mit kleinen Körnern und minimalen Ausscheidungen, weshalb in einem nachfolgenden Strukturierungsschritt diese Schicht unmittelbar strukturiert werden kann. Eine qualitativ hochwertige und zuverlässige Verdrahtung kann auf diese Weise besonders einfach und kostengünstig hergestellt werden.

## Patentansprüche

1. Verfahren zur Herstellung einer Verdrahtung für Kontaktlöcher mit den Schritten:
a) Ausbilden von Kontaktlöchern (3) in einer Isolationsschicht (2) zu einer ersten Verdrahtungsschicht (1);
b) Reinigen einer Oberfläche der Kontaktlöcher (3);
c) Ausbilden einer Barrierenschicht (4) zumindest an der Oberfläche der Kontaktlöcher (3);
d) Ausbilden einer AlGeCu-haltigen zweiten Verdrahtungsschicht (5) an der Oberfläche der Isolationsschicht (2) mittels eines Niedertemperatur-PVD-Verfahrens zum Auffüllen der Kontaktlöcher (3);
e) Ausbilden und Strukturieren einer Maskenschicht (7); und
f) Strukturieren der zweiten Verdrahtungsschicht (5) mittels eines anisotropen Ätzverfahrens unter Verwendung der Maskenschicht (7).

2. Verfahren nach Patentanspruch 1,
**dadurch gekennzeichnet, dass** in Schritt
d) die zweite Verdrahtungsschicht (5) in einem Einstufenprozess durch Abscheiden einer AlGeCu-Schicht bei Substrattemperaturen > 100 Grad Celsius ausgebildet wird.

3. Verfahren nach Patentanspruch 1,
**dadurch gekennzeichnet, dass** in Schritt
d) die zweite Verdrahtungsschicht (5) in einem Zweistufenprozess durch Abscheiden einer ersten AlGeCu-Schicht bei Substrattemperaturen < 100 Grad Celsius und einer zweiten AlGeCu-Schicht bei Substrattemperaturen > 100 Grad Celsius ausgebildet wird.

4. Verfahren nach Patentanspruch 1,
**dadurch gekennzeichnet, dass** in Schritt
d) die zweite Verdrahtungsschicht (5) in einem Zweistufenprozess durch Abscheiden einer AlCu-Schicht bei Substrattemperaturen < 100 Grad Celsius und einer AlGeCu-Schicht bei Substrattemperaturen > 100 Grad Celsius ausgebildet wird.

5. Verfahren nach Patentanspruch 1,
**dadurch gekennzeichnet, dass** in Schritt
d) die zweite Verdrahtungsschicht (5) in einem Dreistufenprozess durch Abscheiden einer ersten AlCu-Schicht, einer AlGeCu-Schicht und einer zweiten AlCu-Schicht ausgebildet wird.

6. Verfahren nach einem der Patentansprüche 1 bis 5,
**dadurch gekennzeichnet, dass** in Schritt
d) die zweite Verdrahtungsschicht (5) einschließlich des Kontaktloches (3) einer abschließenden Wärmebehandlung Unterworfen wird.

7. Verfahren nach einem der Patentansprüche 1 bis 6,
**dadurch gekennzeichnet, dass** in Schritt
d) die zweite Verdrahtungsschicht (5) in einem Mehrstufeprozess durch Abscheiden von zumindest einer AlGeCu-Schicht in den Kontaktlöchern (3), einem nachfolgenden Planarisieren mittels CMP, und durch ganzflächiges Abscheiden einer AlCu-Schicht an der Oberfläche der Isolationsschicht (2) ausgebildet wird.

8. Verfahren nach einem der Patentansprüche 1 bis 7,
**dadurch gekennzeichnet, dass** in Schritt
b) eine nasschemische Reinigung und/oder ein Plasmaätzprozess durchgeführt wird.

9. Verfahren nach einem der Patentansprüche 1 bis 8,
**dadurch gekennzeichnet, dass** in Schritt
c) eine Ti-Haftschicht als Barrierenschicht (4) ausgebildet wird.

10. Verfahren nach einem der Patentansprüche 1 bis 9,
**dadurch gekennzeichnet, dass** vor Schritt
e) eine Antireflexionsschicht (6) an der Oberfläche der zweiten Verdrahtungsschicht (5) ausgebildet wird.

11. Verfahren nach einem der Patentansprüche 10,
**dadurch gekennzeichnet, dass** eine TiN-Schicht als Antireflexionsschicht (6) ausgebildet wird.

12. Verfahren nach einem der Patentansprüche 1 bis 11,
**dadurch gekennzeichnet, dass** in Schritt
d) in Ge-haltiges AlCu-Target zum Ausbilden der zweiten Verdrahtungsschicht (5) verwendet wird.

13. Verfahren nach einem der Patentansprüche 1 bis 11,
**dadurch gekennzeichnet, dass** in Schritt
f) ein reaktives Ionenätzen durchgeführt wird.
